# EUROPEAN PATENT APPLICATION

(11) **EP 2 131 499 A1**
(43) Date of publication of application: **09.12.2009**
(21) Application number: 08157419.6
(22) Date of filing: 02.06.2008
(51) Int. Cl.: H03L 7/197, H03M 7/00

(54) **Digital accumulator with configurable resolution and Sigma-Delta modulator comprising it**

(71) Applicant: Seiko Epson Corporation, Shinjuku-ku Tokyo 163-0811 (JP)
(72) Inventor: Redondo Navarro, Xavier, 08193 Barcelona (ES); Pallarès Cuxart, Jofre, 08193Barcelona (ES); Serra Graells, Francesc, 08193 Barcelona (ES); Terés Terés, Lluís, 08193 Barcelona (ES); Cairo Molins, Josep Ignasi, 08190 Sant Cugat del Vallés (Barcelona) (ES); Gil Gali, Ignacio, 08190 Sant Cugat del Valles (Barcelona) (ES); Tanaka, Kazuaki, 08190 Sant Cugat del Vallés (Barcelona) (ES)
(74) Representative: Carpintero Lopez, Francisco

(57) **Abstract**

The invention refers to a digital accumulator with reconfigurable resolution (10) an input signal of which has *m*+*n* bits, the digital accumulator comprises:
- a first adding means (20, 20') and a first register means (40) in series connection, said first adding means having as addends the *m* most-significant-bits MSB of the input signal (60) and the output (41) of the first register means,
- a second adding means (30, 30') and a second register means (50) in series connection, said second adding means having as addends the n least-significant-bits LSB of the input signal (60) and the output (51) of the second register means; and,
- input means for an enabling signal (70), which input means are connected so as to have an effect on operation of both the second adding means (30) and the second register means (50), and in response to activating said enabling signal the least-significant-bits of the input signal are set to 0 at the second adding means and the second register means are reset

The invention also refers to a sigma-delta modulator comprising at least one of such digital accumulators

## Description

### Field of the invention

The present invention is related to the field of wireless telecommunication systems, in particular to frequency synthesizers based on Phase Locked Loops (PLLs) that use digital Sigma-Delta modulators to divide a high frequency signal.

### Background of the invention

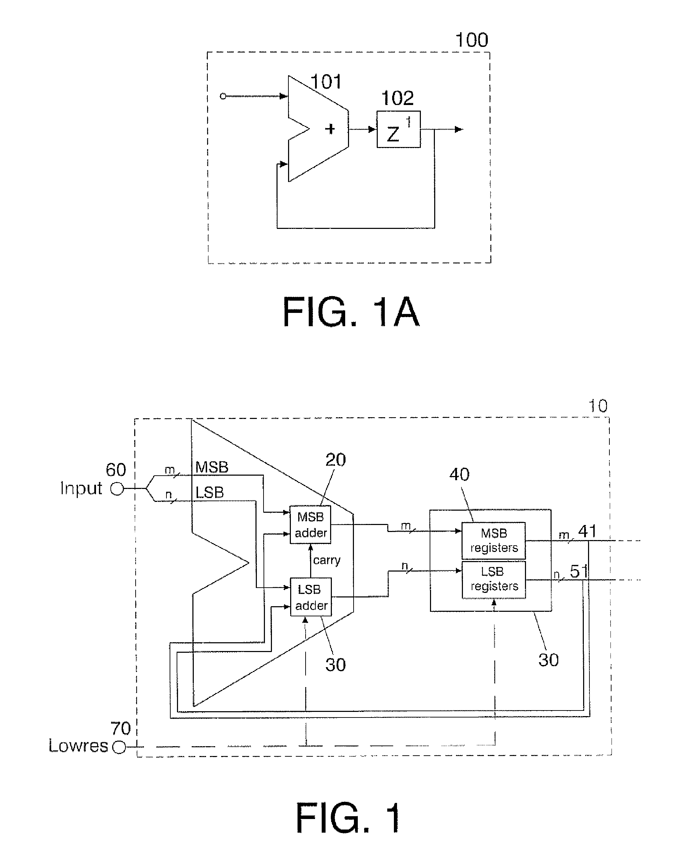

The digital accumulator is the main part of typical sigma-delta modulators, wherein the order of filtering function of the modulator depends directly on the number of accumulators used. As shown in figure 1A, a digital accumulator 100 mainly consists in an adder section 101 and a register array 102.

At present, frequency synthesizers based on a phase-locked loop (PLL) are widely used to generate local oscillation signal in RF wireless applications. Fractional-N synthesizers are commonly used because of their higher reference frequency, better phase noise and setting time in comparison with integer-N ones. A multi-mode divider controlled by a sigma-delta modulator can produce a fractional divide ratio. Therefore, a simple accumulator can also be used to control the divider but generating unwanted noise spurs.

In "Sigma-Delta Modulator with Feedback Dithering for RF Fractional-N Frequency Synthesizer", Liu et al (Proceedings of the 2005 IEEE Conference on Electron Devices and Solid-State Circuits, 19-21 Dec. 2005, pp 137-139) a sigma-delta modulator (SDM) structure with feedback dither is proposed for a fractional-N frequency synthesizer in RF applications. The sigma-delta modulator is simplified by fully reusing the self-generating signal of a conventional SDM, a filter reshapes this output signal, and feeds back into the conventional SDM as dithering. The main part of the modulator is an 8-bit MASH 1-1-1 (Multi Stage Noise Shaping), which modulates an 8-bit input into a 3-bit output An accumulator is used to generate a dither signal, which feedbacks the dither signal into the MASH 1-1-1 to improve the spectrum performance.

In "Reduced Complexity, High Performance Digital Della-Sigma Modulator for Fractional-N Synthesis", Sun et al (Proceedings of the 1999 IEEE International Symposium on Circuits and Systems, 30 May-2 June 1999 Vol. 2, pp 152-155) a high order digital sigma-delta modulator used as modulus controller for a fractional-N frequency synthesizer is proposed. A third order MASH structure (MASH 1-2) is designed and implemented which allows for the input to operate over 75% of the input adder capacity.

There is an important issue related to the power consumption in the sigma-delta modulator when a PLL is used in RF wireless applications (i.e. Bluetooth® applications), wherein a high precision input is required when the system is emitting; however, there is no such need for high precision in reception, but current sigma-delta modulators just operate at a single working mode.

### Summary of the invention

The invention refers to a digital accumulator with configurable resolution according to claim 1. Preferred embodiments of the digital accumulator are defined in the dependent claims.

The present invention is related to a digital accumulator that can operate at different working modes: at a full internal resolution mode and at lower internal resolution mode by enabling/disabling operation of the least-significant-bits LSB of the input signal.. As a consequence, power consumption is reduced when high precision is not needed, i.e in reception, when the digital accumulator is operated in the low resolution mode.

A first aspect of the invention relates to a digital accumulator with reconfigurable resolution, an input signal of which has *m*+*n* bits, which digital accumulator comprises:
- a first adding means and a first register means in series connection, said first adding means having as addends the *m* most-significant-bits MSB of the input signal and the output of the first register means;
- a second adding means and a second register means in series connection, said second adding means having as addends the *n* least-significant-bits LSB of the input signal and the output of the second register means; and,
- input means for an enabling signal, which input means are connected so as to have an effect on operation of both the second adding means and the second register means, and in response to activating said enabling signal the least-significant-bits LSB of the input signal are set to 0 at the second adding means and the second register means are reset

Namely, according to the invention an enabling signal is inputted to the digital accumulator, and within the accumulator said enabling signal affects the operation of the second adding means and to the second register means; and in response to activating said enabling signal the least-significant-bits LSB of the input signal are disabled.. Therefore, operation of the digital accumulator at a full resolution or a lower resolution depends on the state of said enabling signal

The enabling signal can be directly inputted to both the second adding means and the second register means In this case, by activating the enabling signal the least-significant-bits LSB of the input signal are set to 0 at the second adding means and the second register means are reset.

Alternatively, in the case of a digital accumulator with overflow capabilities, the enabling signal can be directly inputted to the second register means and to an actuator of a switching means, which switching means is arranged to connect a carry in of the first adding means to a carry out of the second adding means, or to an external carry in signal in response to activating said enabling signal.

The invention also refers to a sigma-delta modulator, which comprises at least one digital accumulator as defined herein-before.

### Brief description of the drawings

To complete the description and in order to provide for a better understanding of the invention, a set of drawings is provided. Said drawings form an integral part of the description and illustrate preferred embodiments of the invention, which should not be interpreted as restricting the scope of the invention, but just as examples of how the invention can be embodied. The drawings comprise the following figures:
Figure 1A shows a conventional digital accumulator
Figure 1 shows a first embodiment of a digital accumulator with reconfigurable resolution according to the present invention.
Figure 2 shows the equivalent architecture of the digital accumulator shown in Figure 1 when the enabling signal LOWRES is activated
Figure 3 shows a second embodiment of a digital accumulator with reconfigurable resolution according to the present invention.
Figure 4 shows the equivalent architecture of the digital accumulator shown in Figure 3 when the enabling signal LOWRES is activated.

### Detailed description of the referred embodiments

As explained before, figure 1A shows the main structure of a conventional digital accumulator 100. an adder section 101 and a register array 102.

Figure 1 shows a first preferred embodiment of a digital accumulator with reconfigurable resolution 10 according to the present invention.

The digital accumulator 10 includes:
- a first MSB adder 20 for adding the *m* most-significant-bits MSB of an input signal 60, the input signal having m+n bits;
- a second LSB adder 30 for adding the *n* least-significant-bits LSB of the input signal;
- a first MSB register 40 and a second LSB register 50, in series connection with the first and second adders, respectively, the respective outputs of which 41, 51 are connected to the inputs of the first and second adders, respectively..

The digital accumulator also comprises an input 70 for an enabling signal 'Lowres', which is directly connected to the second LSB adder and to the second LSB register.

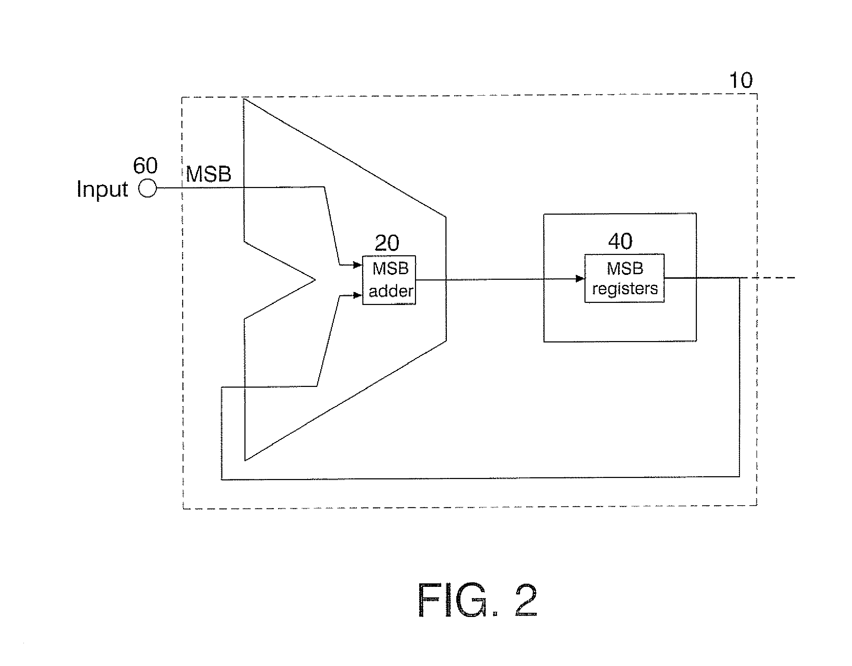

When the enabling signal 'Lowres' is activated, the least-significant-bits LSB of the input signal are set to 0 and the LSB registers are reset, so operation of all LSB sections is disabled. The equivalent architecture of the digital accumulator when the enabling signal 'Lowres' is activated is depicted in Figure 2.

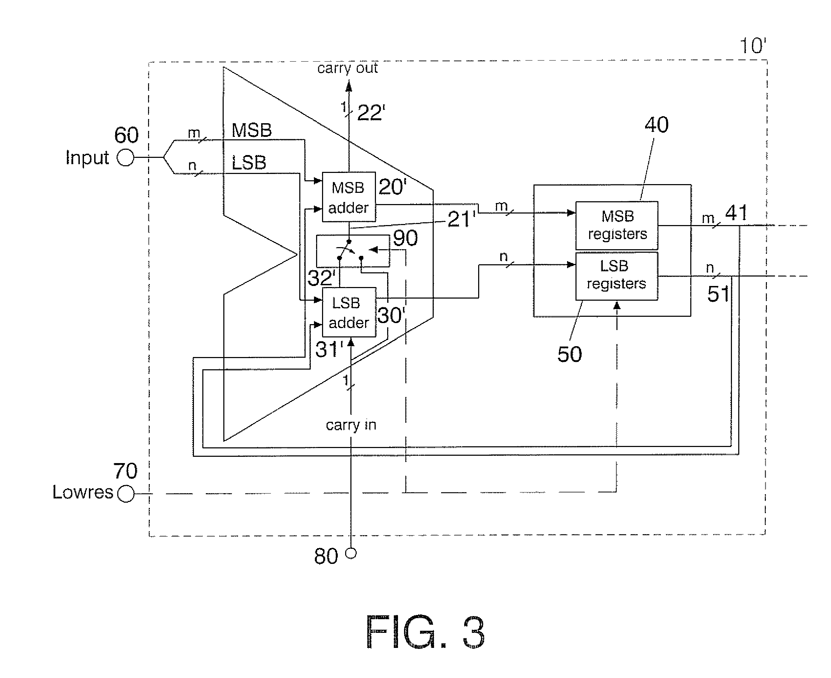

Figure 3 shows a second preferred embodiment of a digital accumulator with reconfigurable resolution 10' according to the present invention.

The digital accumulator 10' has overflow capabilities, and includes:
- a first MSB full-adder 20' for adding the *m* most-significant-bits MSB of an input signal 60, the input signal having m+n bits, which adder has carry in 21' and carry out 22';
- a second LSB full-adder 30' for adding the *n* least-significant-bits LSB of the input signal, which adder has carry in 31' and carry out 32';
- a first MSB register 40 and a second LSB register 50, in series connection with the first and second adders, respectively, the respective outputs of which 41, 51 are connected to the inputs of the first and second adders, respectively;
- a switch 90, which connects a carry-in of the first MSB full adder 20' to a carry-out of the second LSB full adder 30' or directly to an external carry-in signal 80.

The digital accumulator also comprises an input 70 for an enabling signal 'Lowres', which is directly connected to an actuator of the switch and to the second LSB register

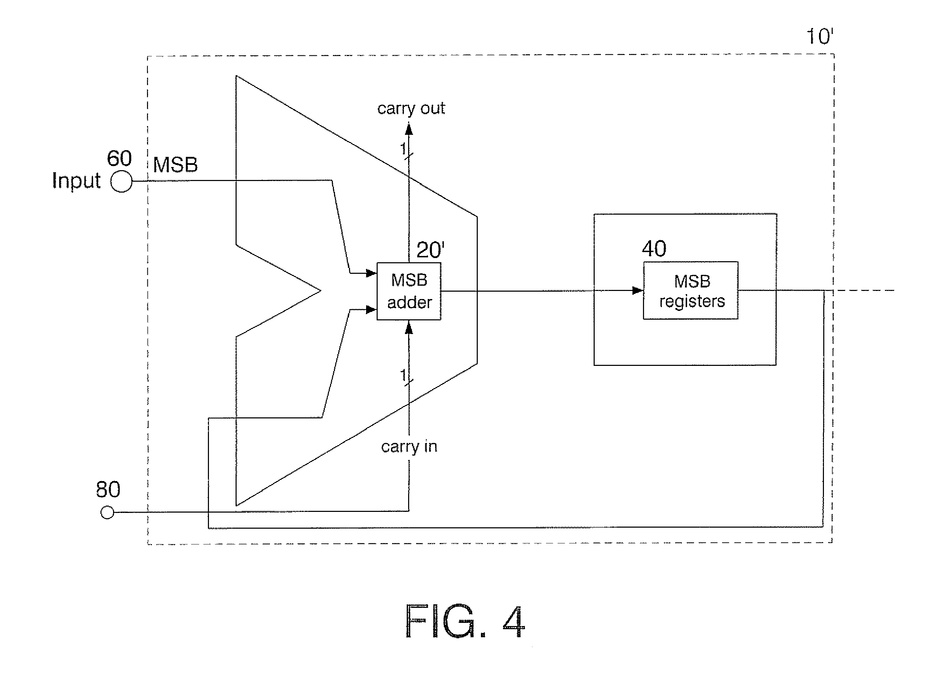

When the enabling signal 'Lowres' is activated, the external carry-in signal is directly inputted as carry-in of the first MSB full adder, and the LSB registers are reset, so operation of all LSB sections is disabled. The equivalent architecture of this second embodiment of the digital accumulator 10' when the enabling signal 'Lowres' is activated is depicted in Figure 4.

An example of application is a sigma-delta modulator having at least one digital accumulator according to the present invention. Such sigma-delta modulator can work both at full internal resolution, e.g. *m*+*n* bits and also at lower internal resolution, e.g. *m*-bits, by disabling the operation of the *n* least-significant-bits.

This kind of modulator uses accumulators with carry-in and carry-out (overflow) capabilities. So the digital accumulator used is the one shown in figure 3 (and figure 4), which uses full-adders instead of simple adders. When activating the enabling signal 'Lowres', the LSB adder and register are disabled, and the carry-in signal is rerouted directly to the first MSB full-adder, resulting finally in the equivalent circuit shown in Figure 4.

An important advantage of this structure is the power saved when operating the sigma-delta modulator in the low resolution mode, i.e. LSB disabled A suitable application is in the control of the divider in fractional PLLs, where the sigma-delta modulator can operate at full resolution when emitting (i.e. channel selection + data modulation), and at lower resolution when receiving (i.e. channel selection only).

Taking into account that the accumulators represent the main part of the SDM circuitry (approximately 80%), and considering a sigma-delta modulator with *n*=*m*=8, it can be calculated that a 40% of the total SDM power consumption is saved when operating at low resolution mode.

Another advantage of this feature is the noise reduction of the digital circuitry. PLL structures integrated in monolithic substrates suffer from electrical noise coming from the switching activity of digital parts. A reduction of this switching activity therefore reduces the amount of noise injected to the sensitive parts of the PLL.

As indicated before, the present invention relates to a digital accumulator and a sigma-delta modulator comprising such digital accumulator. It is to be understood that the above disclosure is an exemplification of the principles of the invention and does not limit the invention to the illustrated embodiments.

## Claims

1. Digital accumulator with reconfigurable resolution (10) an input signal of which has *m*+*n* bits, the digital accumulator comprises:
- a first adding means (20, 20') and a first register means (40) in series connection, said first adding means having as addends the *m* most-significant-bits MSB of the input signal (60) and the output (41) of the first register means;
- a second adding means (30, 30') and a second register means (50) in series connection, said second adding means having as addends the *n* least-significant-bits LSB of the input signal (60) and the output (51) of the second register means; and,
- input means for an enabling signal (70), which input means are connected so as to have an effect on operation of both the second adding means (30) and the second register means (50), and in response to activating said enabling signal the least-significant-bits of the input signal are set to 0 at the second adding means and the second register means are reset.

2. . Digital accumulator according to claim 1, wherein said input means for an enabling signal are directly connected to the second register means (51') and to an actuator of a switching means (90), which switching means is arranged to connect a carry in (21') of the first adding means (20') to a carry out (32') of the second adding means (30'), or to an external carry in signal (80) in response to activating said enabling signal.

3. Digital accumulator according to claim 1, wherein said input means for an enabling signal are directly connected to both the second adding means (30) and the second register means (50).

4. Sigma-delta modulator comprising at least one digital accumulator according to any preceding claim.
